# EUROPÄISCHE PATENTSCHRIFT

(11) **EP 0 407 878 B1**
(45) Veröffentlichungstag und Bekanntmachung des Hinweises auf die Patenterteilung: **05.11.1997**
(21) Anmeldenummer: 90112753.0
(22) Anmeldetag: 04.07.1990
(51) Int. Cl.: G01R 33/32

(54) **Verfahren und Vorrichtung zum Kalibrieren einer Hochfrequenz-Feldstärke in einem Messraum eines Kernspintomographen**
Process and apparatus for calibrating the intensity of a high frequency field intensity in the measure volume of an NMR tomograph
Procédé et appareil pour calibrer l'intensité d'un champ haute fréquence dans le volume de mesure d'un tomographe RMN

(30) Priorität: 13.07.1989 DE 3923069
(43) Veröffentlichungstag der Anmeldung: 16.01.1991
(73) Patentinhaber: Bruker Medizintechnik GmbH, D-76287 Rheinstetten (DE)
(72) Erfinder: Ratzel, Dieter, Dipl.-Ing., D-7512 Rheinstetten-Forchheim (DE)
(74) Vertreter: Witte, Alexander, Dr.-Ing.

(56) Entgegenhaltungen:
- EP-A- 0 206 057
- WO-A-88/09928
- DE-A- 3 706 799
- US-A- 3 873 909

## Beschreibung

Die Erfindung betrifft ein Verfahren zum Kalibrieren einer ersten Hochfrequenz-Feldstärke in einem von einer Hochfrequenzspule umgebenen und mit einem Meßobjekt besetzten Meßraum eines Kernspintomographen.

Ein Verfahren der vorstehend genannten Art ist aus dem Dokument WO-A-88/09928 bekannt.

Die Erfindung betrifft ferner eine Vorrichtung für die Kernspintomographie mit einem von einer Hochfrequenzanordnung umgebenen und mit einem Meßobjekt besetzbaren Meßraum, wobei die Hochfrequenzanordnung über einen Verstärker mit einem Hochfrequenzstrom beaufschlagbar ist und eine zum Senden und Empfangen von Kernspintomographie- Hochfrequenzsignalen vorgesehene Hochfrequenzspule umfaßt.

Eine Vorrichtung der vorstehend genannten Art ist aus dem Dokument EP-A-0 206 057 bekannt.

Aus den Dokumenten WO-A-88/09928 und WO-A-88/09929 sind Verfahren zum Kalibrieren der Amplitude einer Hochfrequenzanregung einer bildgebenden Kernresonanzanordnung bekannt. Bei den bekannten Verfahren werden Hochfrequenz-Probeimpulse auf das Meßobjekt, üblicherweise einen menschlichen Körper, eingestrahlt und die empfangenen Resonanzsignale ausgewertet. Durch Wahl der Impulsform und -folge der Kernresonanz-Anregungsimpulse kann bei Auswertung der Meßsignale die Amplitude der Hochfrequenzanregung in absoluten Werten bestimmt werden.

Aus dem Dokument EP-A-0 238 139 ist ein bildgebendes Kernresonanzverfahren bekannt, bei dem der sog. Pulswinkel, d.h. die zeitliche Länge der Hochfrequenz-Anregungsimpulse, dadurch bestimmt wird, daß wiederum eine vorbestimmte Impulsfolge auf ein Meßobjekt eingestrahlt und die Meßsignale ausgewertet werden.

Aus dem Dokument EP-B-0 152 069 ist eine bildgebende Kernresonanz-Anordnung bekannt, bei der im Meßraum, in unmittelbarer Nähe des Meßobjektes, d.h. des menschlichen Körpers, genormte Referenzproben angeordnet sind. Durch Vergleich der empfangenen Meßsignale, die von den Referenzproben herrühren mit den Meßsignalen, die vom Meßobjekt herrühren, kann eine Skalierung der Meßsignale des Meßobjektes bewirkt werden.

Aus dem Dokument EP-A-0 206 057 ist ferner ein Probenkopf für die NMR-Tomographie bekannt, der im wesentlichen die Gestalt eines Hohlzylinders aufweist, dessen Außen- und Stirnflächen hochfrequenztechnisch geschlossen und dessen zylindrische Innenfläche in leitende und nichtleitende axiale Streifen unterteilt ist. In dem bekannten Probenkopf wird ein im wesentlichen homogenes magnetisches Hochfrequenzfeld erzeugt, dessen Richtung senkrecht zur Achse des Probenkopfes steht.

Aus dem Dokument DE-A-37 06 799 ist ein Magnetresonanz-Datenerfassungssystem bekannt. Bei dieser bekannten Vorrichtung ist außen an einem Magnetsystem eines Kernspintomographen eine als Sendeantenne betriebene Eichantenne angebracht, die über einen HF-Eichgenerator sowie einen Eichwiderstand gespeist wird. Die Frequenz des eingespeisten Signals entspricht der NMR-Resonanzfrequenz eines zu untersuchenden Patienten. Die bekannte Vorrichtung wird zunächst dadurch geeicht, daß ein Phantom, d.h. ein Testobjekt mit Wassergefäßen, in das Magnetsystem eingesetzt wird. Die Signalamplitude des HF-Eichsignals wird nun so eingestellt, bis am Ausgang einer Kernspin-Meßvorrichtung ein Signal einer bestimmten Amplitude erscheint. Das Phantom ist dabei so klein ausgebildet, daß es keine merkliche elektrische Belastung für das System darstellt. Für eine Messung an einem Patienten wird nun zunächst der Patient in das Magnetsystem eingebracht. In Abwesenheit weiterer Meßsignale wird nun die Eichantenne zunächst erneut mit dem zuvor eingestellten HF-Eichsignal beaufschlagt. Das sich nun am Ausgang der Kernspin-Meßvorrichtung einstellende Signal ist wegen der elektrischen Belastung des Magnetsystems durch den Patienten ein anderes, als dies zuvor während des Eigvorganges gemessen wurde. Die Kernspin-Meßvorrichtung wird nun in ihrem Verstärkungsfaktor so nachgestellt, bis sich am Ausgang wieder das Signal bestimmter Amplitude einstellt.

Bekanntlich wird in der Kernspintomographie das Meßobjekt, z.B. ein Teil eines menschlichen Körpers oder ein gesamter menschlicher Körper, in einen Meßraum gebracht, der sowohl von einer Hochfrequenzspule wie auch von einem Magnetsystem, von Gradientenspulen und dgl. umgeben ist, wie dies an sich bekannt ist. Das zu untersuchende Meßobjekt wird dabei einem Konstantmagnetfeld hoher Homogenität und einem Hochfrequenz-Magnetfeld ausgesetzt, das zum Konstantmagnetfeld unter einem rechten Winkel ausgerichtet ist.

Wenn in diesem Zusammenhang nachfolgend von "Hochfrequenzspule" die Rede ist, so soll hierunter jedwedes Hochfrequenzsystem verstanden werden, das in der Lage ist, in einem größeren räumlichen Bereich ein Hochfrequenz-Magnetfeld ausreichender Homogenität und Feldstärke zu erzeugen. Derartige Anordnungen können z.B. als Sattelspulen, Helmholtz-Spulen, Leitungsresonatoren, Bandresonatoren und dgl. ausgebildet sein. Besonders bevorzugt im Rahmen der vorliegenden Erfindung ist ein hohlzylindrischer Hochfrequenzresonator, wie er in der bereits weiter oben erwähnten EP-A-0 206 057 beschrieben ist; die Erfindung ist jedoch nicht auf eine derartige Probenkopfanordnung beschränkt.

Bekanntlich wird zur Erzeugung von Kernresonanzsignalen in der Kernspintomographie ein gepulstes, d.h. getastetes Hochfrequenzsignal verwendet, dessen Frequenz proportional zur Feldstärke des Konstantmagnetfeldes ist.

Durch eine derartige gepulste Anregung der Spins wird die Magnetisierung aus der Richtung des Konstantmagnetfeldes um einen bestimmten Winkel gekippt. Dieser Winkel, der sog. "Flipwinkel" ist dabei durch die Impulsfläche, d.h. die Hüllkurve des getasteten Hochfrequenzsignales oder Bursts bestimmt. Man kann also, mit anderen Worten, den Flipwinkel sowohl über die Impulslänge wie auch über die Impulsamplitude einstellen.

Zur Erzeugung maximaler Meßsignale, d.h. einer optimalen Kernresonanz-Anregung, werden Impulse eingestrahlt, deren Flipwinkel 90° oder 180° beträgt, um die Magnetisierung entweder in eine Radialebene zu kippen oder in eine Antimagnetisierung, mit umgekehrtem Vorzeichen, zu überführen.

Aus diesem Grunde ist man bestrebt, den Flipwinkel beim Einstellen des Kernspintomographen möglichst genau auf den Wert von 90° bzw. 180° einzustellen, um eine möglichst große Signalausbeute zu erzielen.

Nun ist jedoch bei der Einstellung der Hochfrequenzeinstrahlung die Bemessung der Impulslänge technisch kein Problem, weil durch geeignete Zeitsteuerungen und Torschaltungen eine Impulsdauer mit hinreichender Präzision bei vertretbarem Aufwand eingestellt werden kann.

Da aber andererseits, wie erwähnt, der Flipwinkel nicht nur von der Impulslänge sondern auch von der Impulsamplitude abhängt, ist es zusätzlich erforderlich, die Impulsamplitude, d.h. die am Probenort wirksame Amplitude des Hochfrequenz-Magnetfeldes, einzustellen.

Die Amplitude des magnetischen Hochfrequenzfeldes ist nun jedoch nicht allein proportional zur Amplitude des Hochfrequenz-Erregerstromes in der Spule. Die Amplitude des magnetischen Hochfrequenzfeldes hängt nämlich vielmehr zusätzlich von der Art der Beladung des Hochfrequenz-Resonanzkreises ab. Wenn beispielsweise in ein- und derselben Hochfrequenzspule einmal ein sehr kleiner oder ein sehr magerer Patient, zum anderen aber ein adipöser Patient untersucht werden soll, so ändert sich der sog. Füllfaktor, weil das Gewebe des Patienten sowohl zu dielektrischen Verlusten wie auch zu magnetischen Verlusten infolge von Wirbelströmen im Patienten führt. Außerdem kann eine Änderung der Belastung des Hochfrequenz-Resonanzkreises dann eintreten, wenn der sehr kleine oder magere Patient oder ein Körperteil eines Patienten die Hochfrequenz-Spule nicht vollkommen ausfüllt und die Lage dieses Meßobjektes innerhalb der Hochfrequenzspule nicht definiert ist.

In all diesen Fällen ist die Abhängigkeit des wirksamen Hochfrequenz-Magnetfeldes vom Hochfrequenz-Erregerstrom vollkommen undefiniert, so daß eine Einstellung des Erregerstromes in keiner Weise zu kalibrierten Verhältnissen hinsichtlich der Hochfrequenz-Feldstärke führt.

Hierbei ist zusätzlich zu beachten, daß es in verschiedenen Ländern gesetzliche Bestimmungen gibt, die eine Höchstbelastung des menschlichen Körpers mit Hochfrequenzbestrahlung vorschreiben. So wird beispielsweise in den USA durch die dort zuständige FDA eine Grenze von 0,4 W wirksame Hochfrequenzleistung pro kg Körpergewicht des Patienten im Probenraum festgelegt.

Es ist daher nicht nur im Interesse der Signalmaximierung sondern auch im Interesse der Sicherheit der Patienten erforderlich, die wirksame Hochfrequenz-Feldstärke, d.h. die Amplitude des Hochfrequenz-Magnetfeldes zu kalibrieren, d.h. reproduzierbar einzustellen.

Bei üblichen Kernspintomographen geht man hierzu so vor, daß bei besetztem Probenraum, d.h. bei in die Apparatur eingeschobenem Patienten, Kernresonanz-Probemessungen mit zunächst willkürlich eingestellter Amplitude des magnetischen Hochfrequenzfeldes durchgeführt werden. Der Benutzer des Kernspintomographen beobachtet dann an einem Bildschirm das Signal des freien Induktionsabfalls (FID) des Kernresonanzsignals, dessen Amplitude sich mit der üblicherweise von Hand einstellbaren Amplitude des magnetischen Hochfrequenzfeldes ändert. Durch Probieren, d.h. durch willkürliches Verstellen der Amplitude wird nun der Punkt gesucht, an dem das FID-Signal sein Maximum hat, weil bei noch höherer Amplitude (immer bezogen auf eine konstante Impulslänge) der Flip-Winkel von z.B. 90° überschritten würde, was wiederum zu einer Signalverminderung führen würde.

Diese herkömmliche, empirische Vorgehensweise ist jedoch mit mehreren Nachteilen behaftet:

Zum einen ist diese Art der Einstellung äußerst zeitaufwendig, weil für eine zuverlässige Beurteilung des FID-Signales mehrere Scans abgewartet werden müssen, so daß pro Testmessung beispielsweise 5 bis 10 Sekunden gewartet werden müssen. In der Praxis führt dies entweder dazu, daß nach Ablauf dieser Zeit schon nicht mehr bekannt ist, welches der zuvor eingestellte Meßwert war, oder aber ein ungeduldiger Benutzer des Kernspintomographen wartet den genannten Zeitraum nicht ab und wiederholt die Messungen in schnellerer Folge, wodurch sich jedoch zahlreiche Fehler einschleichen können, beispielsweise infolge dynamischer Effekte.

Weiterhin können sich erhebliche Fehler dadurch ergeben, daß das gesuchte Maximum des FID-Signales nicht eindeutig ist. Wenn beispielsweise ein 180°-Impuls über das Maximum des Echo-Signales ermittelt werden soll, so ist ein entsprechendes Maximum auch bei 540°, allgemein also bei einem 2n-1-fachen des an sich gewünschten Flip-Winkels zu finden. Es kann daher durchaus sein, daß der Benutzer des Kernspintomographen statt eines 180°-Impulses einen 540°-Impuls einstellt, was jedoch zur Folge hat, daß die Amplitude des Hochfrequenz-Magnetfeldes um einen Faktor 3 zu hoch ist.

Derartige Fehleinstellungen sind in der Praxis durchaus möglich, weil Kernspintomographen hinsichtlich der Hochfrequenz-Ausgangsleistung so ausgelegt werden müssen, daß sowohl sehr kleine Meßobjekte (Kleinkinder) wie auch sehr große Meßobjekte (adipöse Patienten) gemessen werden können. Während beispielsweise im erstgenannten Fall eine Hochfrequenzleistung von 100 W ausreichend wäre, kann im zweitgenannten Fall eine Hochfrequenzleistung von 2000 W erforderlich sein. Bei dieser Leistungsreserve ist es jedoch im Falle der Messung eines kleinen Meßobjektes durchaus möglich, durch Einstellen einer hohen Hochfrequenzleistung einen Flip-Winkel höherer Ordnung bei entsprechend hoher und möglicherweise gefährlicher Hochfrequenzleistung einzustellen.

Der Erfindung liegt daher die Aufgabe zugrunde, ein Verfahren und eine Vorrichtung der eingangs genannten Art dahingehend weiterzubilden, daß ohne die Notwendigkeit einer Kernresonanzmessung eine Eichung oder Kalibrierung der Hochfrequenz-Feldstärke auch bei geringer Hochfrequenzleistung möglich ist, so daß Schäden für die Patienten mit Sicherheit vermieden werden.

Gemäß dem eingangs genannten Verfahren wird diese Aufgabe erfindungsgemäß dadurch gelöst, daß zum Kalibrieren der ersten Hochfrequenzfeldstärke keine Kernspinresonanzmessung durchgeführt wird sondern vielmehr eine Hochfrequenzmessung an sich, indem die Hochfrequenzspule zunächst mit einem Hochfrequenzstrom vorgegebener Stromstärke gespeist und eine sich infolgedessen einstellende zweite Hochfrequenz-Feldstärke an mindestens einer Position außerhalb des Meßraumes gemessen wird, wobei ferner aus der vorgegebenen Stromstärke, der gemessenen zweiten Feldstärke, einer vorgegebenen ersten Proportionalität zwischen der ersten und der zweiten Feldstärke eine zweite Proportionalität zwischen dem die Hochfrequenzspule durchfließenden Strom und der ersten Feldstärke ermittelt und schließlich anhand der zweiten Proportionalität durch Einstellen eines Meßstromes in der Hochfrequenzspule eine gewünschte, kalibrierte erste Feldstärke in der Hochfrequenzspule erzeugt wird.

Gemäß der eingangs genannten Vorrichtung wird die der Erfindung zugrundeliegende Aufgabe dadurch gelöst, daß zum Kalibrieren einer ersten Hochfrequenzfeldstärke in dem Meßraum ohne Durchführung einer Kernspinresonanzmessung eine zusätzlich zu der Hochfrequenzspule vorgesehene Meßspule außerhalb des Meßraumes angeordnet ist, und daß der Hochfrequenzstrom in Abhängigkeit von einem Ausgangssignal der Meßspule einstellbar ist, zu welchem Zweck der Verstärker der erfindungsgemäßen Vorrichtung in seinem Verstärkungsfaktor einstellbar ist und ein Verstärkungs-Steuereingang des Verstärkers an einen Regler angeschlossen ist, dessen Eingang mit der Meßspule verbunden ist.

Die der Erfindung zugrundeliegende Aufgabe wird auf diese Weise vollkommen gelöst. Im Gegensatz zu den bekannten Verfahren und Vorrichtungen wird nämlich erfindungsgemäß zum Kalibrieren der Hochfrequenz-Feldstärke keine Kernresonanzmessung durchgeführt sondern vielmehr eine Hochfrequenzmessung an sich, indem die Hochfrequenzspule mit dem Hochfrequenzstrom beaufschlagt wird, der lediglich die Frequenz des für die Kernresonanzmessung erforderlichen Hochfrequenzstromes haben muß, jedoch nicht gepulst zu sein braucht. Insbesondere kann der Hochfrequenzstrom auf einen sehr kleinen Wert eingestellt werden, so daß die dadurch hervorgerufene Feldstärke im Meßraum weit unterhalb jeder Gefahrengrenze für den Patienten liegt. In dieser Kalibrierphase wird nämlich lediglich über die Meßspule eine Hochfrequenz-Feldstärke außerhalb des Meßraumes gemessen. Man macht sich nun die Tatsache zunutze, daß die Feldstärke außerhalb des Meßraumes mit vertretbarer Genauigkeit proportional zur Feldstärke innerhalb des Meßraumes ist, und zwar unabhängig von der jeweiligen Belastung der Hochfrequenzspule durch unterschiedliche Meßobjekte. Diese Zusammenhänge lassen sich für jeden Typ von Hochfrequenzspule vorab bestimmen, so daß bei bekanntem Kalibrierstrom und der gemessenen Hochfrequenz-Feldstärke außerhalb des Meßraumes ein Rückschluß auf den jeweils vorliegenden Füllfaktor möglich ist bzw. ein Rückschluß darauf, welcher Meßstrom eingestellt werden muß, um eine gewünschte Hochfrequenz-Meßfeldstärke im Meßraum zu erzeugen.

Die Erfindung eröffnet damit zahlreiche Möglichkeiten, um Kernspintomographie-Messungen durchzuführen. So kann mit der Erfindung entweder ein reines Kalibrierprogramm abgearbeitet werden, dessen Ergebnisse anschließend zur Einstellung des Kernspintomographen dienen. Die Erfindung kann aber auch für eine kontinuierliche Regelung der Hochfrequenz-Feldstärke eingesetzt werden, indem das vorstehend genannte Kalibrierprogramm selbsttätig abläuft und zur kontinuierlichen Einstellung und ggf. Nachregelung der Hochfrequenz-Feldstärke eingesetzt wird, ohne daß der Benutzer des Kernspintomographen jeweils wieder von sich aus manuell ein Kalibrierprogramm starten muß. Schließlich eröffnet die Erfindung die Möglichkeit, eine Sicherheitsschaltung vorzusehen, mit der auch im Falle einer Fehlfunktion im Hochfrequenz-Senderkreis ein zu starkes Hochfrequenz-Magnetfeld erkannt und eine entsprechende Notabschaltung aktiviert wird.

Ferner kann der Verstärker eingangsseitig wahlweise mit einem Kernresonanz-Impulsgenerator oder mit einem kalibrierten Hochfrequenzgenerator verbunden werden, um in der genannten Weise automatisiert oder manuell ein Kalibrierprogramm und ein Meßprogramm abarbeiten zu können.

Schließlich kann für den genannten Anwendungsfall als Alarmgeber die Meßspule an einen mit einem Alarmausgang versehenen Regler angeschlossen sein.

Besonders bevorzugt wird beim erfindungsgemäßen Verfahren und der erfindungsgemäßen Vorrichtung eine Meßspule verwendet, bei der in einem torusförmigen Zwischenraum zwischen einer zylindrischen Innenwand und einer zylindrischen Außenwand eines hohlzylindrischen Bandleitungsresonators die Meßspule zur Messung der Hochfrequenz-Feldstärke außerhalb des Meßraumes angeordnet ist.

Diese Maßnahmen haben den Vorteil, daß die Meßspule hinsichtlich ihrer Lage optimiert und dann in der optimierten Position fixiert werden kann, ohne daß dies den Meßablauf stört, weil der torusförmige Zwischenraum ohnehin unzugänglich ist.

Weitere Vorteile ergeben sich aus der Beschreibung und der beigefügten Zeichnung.

Ausführungsbeispiele der Erfindung sind in der Zeichnung dargestellt und werden in der nachfolgenden Beschreibung näher erläutert. Es zeigen:
- Fig. 1: eine äußerst schematisierte Gesamtansicht eines Kernspintomographen zur Durchführung des erfindungsgemäßen Verfahrens bzw. zur Erläuterung eines Ausführungsbeispiels einer erfindungsgemäßen Vorrichtung;
- Fig. 2: ein Diagramm zur Darstellung der Proportionalität der Hochfrequenz-Feldstärke innerhalb und außerhalb des Meßraumes;
- Fig. 3: ein weiteres Diagramm zur Darstellung der Proportionalität zwischen der Hochfrequenz-Feldstärke im Meßraum und des Erregerstromes, parametriert nach dem Füllfaktor;
- Fig. 4: eine perspektivische Ansicht, teilweise aufgebrochen, eines Probenkopfes, wie er bevorzugt bei der erfindungsgemäßen Vorrichtung bzw. zur Durchführung des erfindungsgemäßen Verfahrens verwendet wird;
- Fig. 5: einen Radialschnitt durch den in Fig. 4 gezeigten Probenkopf.

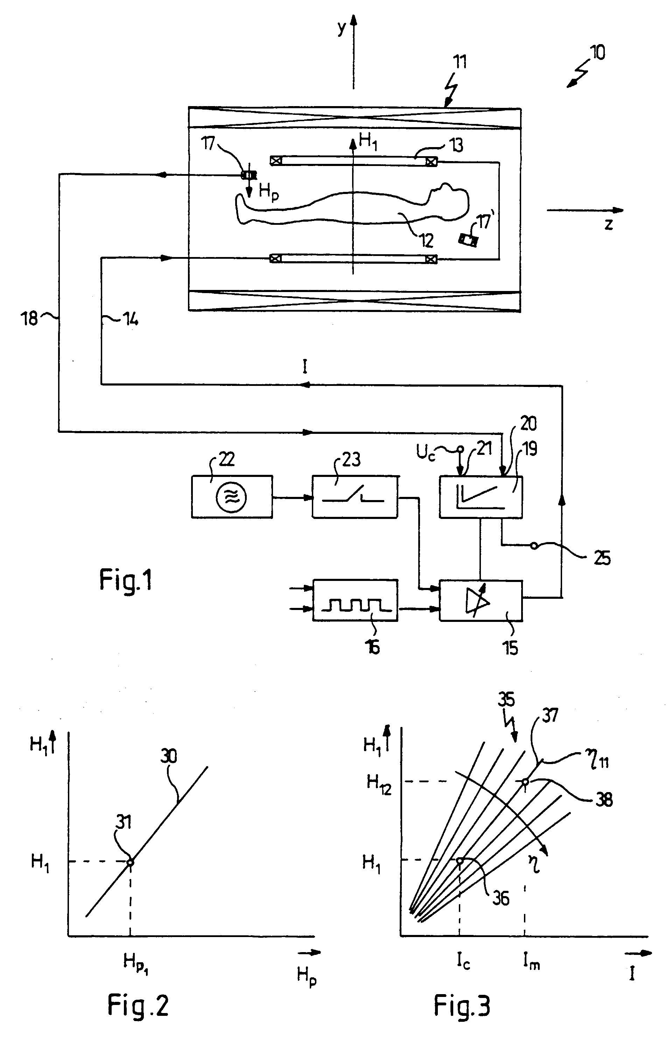

In Fig. 1 bezeichnet 10 insgesamt einen Kernspintomographen. Der Kernspintomograph 10 umfaßt einen Magneten 11 hoher Feldstärke und hoher Homogenität. Der Magnet 11 kann ein normal leitender oder ein supraleitender Magnet sein. Durch den Magneten 11 ist eine Längsachse z und eine darauf senkrecht stehende Achse y definiert.

Ein Patient 12 ist in z-Richtung in den Magneten 11 eingeschoben. Den Patienten 12 umgibt ferner eine Hochfrequenzspule 13, die den Meßraum für den Patienten 12 definiert.

Im Innenraum des Magneten 11 sind ferner noch Gradientenspulen angeordnet, die jedoch in Fig. 1 der Übersichtlichkeit halber nicht dargestellt und im übrigen an sich bekannt sind.

Die Hochfrequenzspule 13 wird über eine Hochfrequenzleitung 14 von einem Verstärker 15 gespeist, der eingangsseitig an einen Impulsgenerator 16 üblicher Bauart angeschlossen ist. Der Impulsgenerator 16 ist in der Lage, Impulsprogramme zu erzeugen, d.h. Folgen von getasteten Hochfrequenzsignalen, bei denen beispielsweise 90°-Impulse und 180°-Impulse zu an sich bekannten Impulsprogrammen verknüpft sind. Auch dies ist an sich bekannt und soll daher hier nicht nochmals erläutert werden.

Im Gegensatz zu bekannten Kernspintomographen ist nun mindestens eine Meßspule 17 oder 17' außerhalb des Meßraumes vorgesehen. Die mindestens eine Meßspule 17 ist über eine Meßleitung 18 an einen Regler 19 angeschlossen, und zwar an einen Meßeingang 20, während ein Referenzeingang 21 des Reglers 19 mit einer Kalibrierspannung U_{c} beschaltet ist. Der Ausgang des Reglers 19 ist an einen Verstärkungs-Steuereingang des in seinem Verstärkungsfaktor einstellbaren Verstärkers 15 angeschlossen.

Ein weiterer Eingang des Verstärkers 15 ist mit einem Hochfrequenzgenerator 22 beschaltet, der in seinem Ausgang mit einem Taster 23 versehen ist.

Schließlich ist der Regler 19 noch mit einem Alarm-Ausgang 25 beschaltet.

Die Wirkungsweise der Vorrichtung gemäß Fig. 1 soll nun anhand der Diagramme der Fig. 2 und 3 erläutert werden.

Für einen normalen Kernresonanz-Meßbetrieb ist der Verstärker 15 eingangsseitig mit dem Impulsgenerator 16 beschaltet. Der Verstärker 15 schickt einen Hochfrequenzstrom I über die Hochfrequenzleitung 14 in die Hochfrequenzspule 13. In dem genannten Betriebsfall wird infolge des Impulsprogrammes bei aufgetasteten Impulsen ein Meßstrom Iₘ in die Hochfrequenzspule 13 geleitet.

Infolgedessen erzeugt die Hochfrequenzspule 13 ein Hochfrequenz-Magnetfeld, dessen Feldstärke H₁ im wesentlichen in y-Richtung verläuft, wie in Fig. 1 dargestellt.

Die Hochfrequenzspule 13 ist elektrisch mit dem Patienten 12 belastet, dessen Körpergewebe sowohl zu dielektrischen Verlusten wie auch, wegen auftretender Wirbelströme, zu magnetischen Verlusten führt. Selbst wenn man daher den Betrag des Meßstromes Iₘ messen würde, wäre dies kein Maß für die wirksame Hochfrequenz-Feldstärke H₁, weil die Güte der Hochfrequenzspule 13 in weiten Bereichen schwanken kann, z.B. zwischen Q = 200 bei weitgehend unbelasteter Spule bzw. sehr kleinem Patienten 12 und Q = 20 bei stark belasteter Spule infolge eines Patienten 12 mit hohem Körpergewicht.

Um nun die Hochfrequenz-Feldstärke H₁ kalibriert, d.h. reproduzierbar einstellen zu können, wird vorab eine Kalibriermessung durchgeführt. Hierzu wird der Impulsgenerator 16 abgeschaltet. Der Verstärker 15 wird stattdessen vom Hochfrequenzgenerator 22 angesteuert, dessen Frequenz der Basisfrequenz des Impulsgenerators 16 entspricht. Durch Betätigen des Tasters 23 wird nun ein Kalibrierstrom I_{c} über die Hochfrequenzleitung 14 in die Hochfrequenzspule 13 eingespeist. Dieser Kalibrierstrom hat eine erste Hochfrequenz-Feldstärke H₁₁ zur Folge, die im Prinzip beliebig niedrig eingestellt werden kann, weil diese Hochfrequenz-Feldstärke nicht dazu dienen soll, um Kernresonanzen im Patienten 12 anzuregen.

Die auf diese Weise erzeugten Feldlinien durchsetzen auch die mindestens eine Meßspule 17, und zwar mit einer Feldstärke Hₚ₁, die üblicherweise anders ist als die wirksame Hochfrequenz-Feldstärke H₁₁, weil sich die Meßspule 17 außerhalb des Meßraumes befindet.

Die Hochfrequenz-Feldstärke Hₚ₁ durchsetzt die Meßspule 17 und induziert in dieser eine Meßspannung, die über die Meßleitung 18 abnehmbar ist.

Man kann nun für jede Art von Hochfrequenzspule 13 durch geeignete Labormessungen feststellen, daß die Feldstärke Hₚ in einer an einer geeigneten Position angebrachten Meßspule 17 proportional zur wirksamen Feldstärke H₁ im Meßraum ist, und zwar weitestgehend unabhängig davon, wie die Hochfrequenzspule 13 durch unterschiedliche Meßobjekte belastet wird. Dies gilt sowohl für unterschiedliche Füllfaktoren wie auch für unterschiedliche Positionen kleinerer Meßobjekte innerhalb der Hochfrequenzspule 13, so daß diese Effekte nachstehend unter dem Begriff "Füllfaktor" zusammengefaßt werden sollen.

Anders ausgedrückt bedeutet dies, daß jedes in die Hochfrequenzspule 13 eingesetzte Objekt unabhängig von Größe und Lage die wirksame Hochfrequenz-Feldstärke H₁ und die in der Meßspule 17 wirksame Feldstärke Hₚ gleichermaßen beeinflußt.

Andererseits ist für eine bestimmte Hochfrequenzspule 13 auch bekannt, daß die wirksame Hochfrequenz-Feldstärke sich bei unverändertem Meßobjekt, d.h. bei konstantem Füllfaktor, proportional mit dem Hochfrequenz-Erregerstrom ändert.

Betrachtet man nun Fig. 2, so sieht man dort eine Gerade 30, die die Proportionalität zwischen der wirksamen Hochfrequenz-Feldstärke H₁ und der in der Meßspule 17 gemessenen Feldstärke Hₚ wiedergibt. Die Gerade 30 ist eine Systemkonstante und kann für eine bestimmte Hochfrequenzspule 13 in der genannten Weise vorab im Labor bestimmt werden.

Wird nun während des weiter oben erläuterten Kalibrierprogramms das bekannte Ausgangssignal des Hochfrequenzgenerators 22 kurzzeitig über den Verstärker 15 auf die Hochfrequenzspule 13 gegeben, d.h. ein kalibrierter Hochfrequenzstrom I_{c} eingestellt und anschließend in der Meßspule 17 eine Hochfrequenz-Feldstärke Hₚ₁ ermittelt, so führt dies auf der Geraden 30 über einen zur Feldstärke Hₚ₁ gehörigen Kalibrierpunkt 31 zu einer wirksamen Hochfrequenz-Feldstärke H₁₁ im Meßraum.

Diese Feldstärke H₁₁ ist also die wirksame Hochfrequenz-Feldstärke im Meßraum, wenn als Hochfrequenz-Erregerstrom der Kalibrierstrom I_{c} wirkt.

Fig. 3 zeigt hierzu ein Diagramm zwischen der wirksamen Hochfrequenz-Feldstärke H₁ und dem jeweils eingespeisten Hochfrequenzstrom I, parametriert nach dem Füllfaktor η. Wie bereits erwähnt, sind H₁ und I zueinander proportional, die jeweilige Proportionalitätskonstante bzw. Steigung der Geraden der Geradenschar 35 der Fig. 3 hängt jedoch vom Füllfaktor η ab.

Andererseits hat man durch das vorstehend beschriebene Kalibrierprogramm einen Meßpunkt im Diagramm der Fig. 3, nämlich den Kalibrierpunkt 36, da dieser durch den Kalibrierstrom I_{c} und die anhand der Fig. 2 ermittelte wirksame Hochfrequenz-Feldstärke H₁₁ definiert ist. Über den Kalibrierpunkt 36 ist damit eine Gerade 37 der Geradenschar 35 und damit auch der jeweilige Füllfaktor η₁₁ festgelegt.

Die Kalibrierung ist damit abgeschlossen, weil für den speziellen Meßfall bzw. den speziellen Patienten 12 oder, physikalisch ausgedrückt, den speziellen Füllfaktor η₁₁ die Verhältnisse, d.h. die Abhängigkeit der wirksamen Hochfrequenz-Feldstärke H₁ vom Hochfrequenz-Erregerstrom I definiert sind.

Will man beispielsweise eine wirksame Hochfrequenz-Feldstärke H₁₂ einstellen, die bei vorgegebener Impulslänge gerade einen Flip-Winkel von 90° oder 180° bedeutet, so braucht lediglich auf der Geraden 37 der zugehörige Hochfrequenz-Meßstrom Iₘ bestimmt zu werden, wie mit einem Meßpunkt 38 in Fig. 3 veranschaulicht.

Wegen der genannten Proportionalität kann man aber auch in einfacher Weise so vorgehen, daß man das Verhältnis H₁₂/H₁₁ bestimmt und den Meßstrom Iₘ auf das entsprechende Vielfache des Kalibrierstroms I_{c} einstellt.

Beim Blockschaltbild der Fig. 1 kann dies über den Regler 19 geschehen, an dessen Referenzeingang 21 die Kalibrierspannung U_{c} und an dessen Meßeingang 20 die Meßspannung der Meßspule 17 anliegt. Die Meßspannung U_{c} repräsentiert dabei den Kalibrierstrom I_{c}, so daß durch Verhältnis- oder Differenzbildung der an den Eingängen 20, 21 anliegenden Signale zusammen mit der bekannten Geraden 30 der Fig. 2 die jeweils vorliegende Abhängigkeit der Hochfrequenz-Feldstärke H₁ vom Hochfrequenzstrom I bestimmt werden kann. Diese Proportionalität bzw. Steigung der Geraden der Geradenschar 35 in Fig. 3 läßt sich nun in einen Verstärkungsfaktor des Verstärkers 15 umsetzen, so daß das in seiner Amplitude vorbestimmte Ausgangssignal des Impulsgenerators 16 in Abhängigkeit von dieser Steigung bzw. dem Verstärkungsfaktor in einen Meßstrom Iₘ umgesetzt wird, der an den jeweiligen Füllfaktor η angepaßt ist.

Zum Kalibrieren des Kernspintomographen 10 braucht daher, wenn der Patient 12 sich im Meßraum befindet, nur kurzzeitig bei abgeschaltetem Impulsgenerator 16 der Taster 23 betätigt zu werden, um den Regler 19 bzw. den Verstärker 15 entsprechend einzustellen. Nach Einschalten des Impulsgenerators 16 kann nun an dessen Ausgang eine Signalamplitude eingestellt werden, die bei dem kalibrierten Verstärkungsfaktor des Verstärkers 15 gerade zu dem gewünschten 90° oder 180°-Impuls führt.

Während der Durchführung der Kernresonanzmessung kann der Regler 19 eine Alarmfunktion ausüben, indem mit der Meßspule 17 das während der Kernresonanzmessung wirkende Hochfrequenzfeld gemessen und über den Referenzeingang 21 mit einem zulässigen Grenzwert verglichen wird. Bei Überschreiten des Grenzwertes wird der Alarmausgang 25 aktiv geschaltet und beispielsweise der Verstärker 15 abgeschaltet.

Die Meßspule 17 kann an unterschiedlichen Positionen relativ zur Hochfrequenzspule 13 angebracht sein. Es wurde bereits erwähnt, daß die jeweilige Position der Meßspule 17 empirisch optimiert werden kann, damit die Gerade 30 der Fig. 2 angegeben werden kann und für alle Belastungszustände der Hochfrequenzspule 13 gilt. In praktischen Versuchen hat sich gezeigt, daß die Proportionalität, d.h. die Steigung der Geraden 30 in Fig. 2 zwar geringfügig vom Füllfaktor der Hochfrequenzspule 13 abhängt, daß diese Variationen jedoch wesentlich geringer sind als diejenigen Fehler, die bei heutzutage üblichen Kernspintomographen 10 im praktischen Betrieb durch ungenaue Einstellung auftreten.

Es können auch mehrere Meßspulen 17, 17' vorgesehen werden, deren Ausgangssignale dann zu einem Gesamtsignal verknüpft werden, z.B. durch Mittelwertbildung.

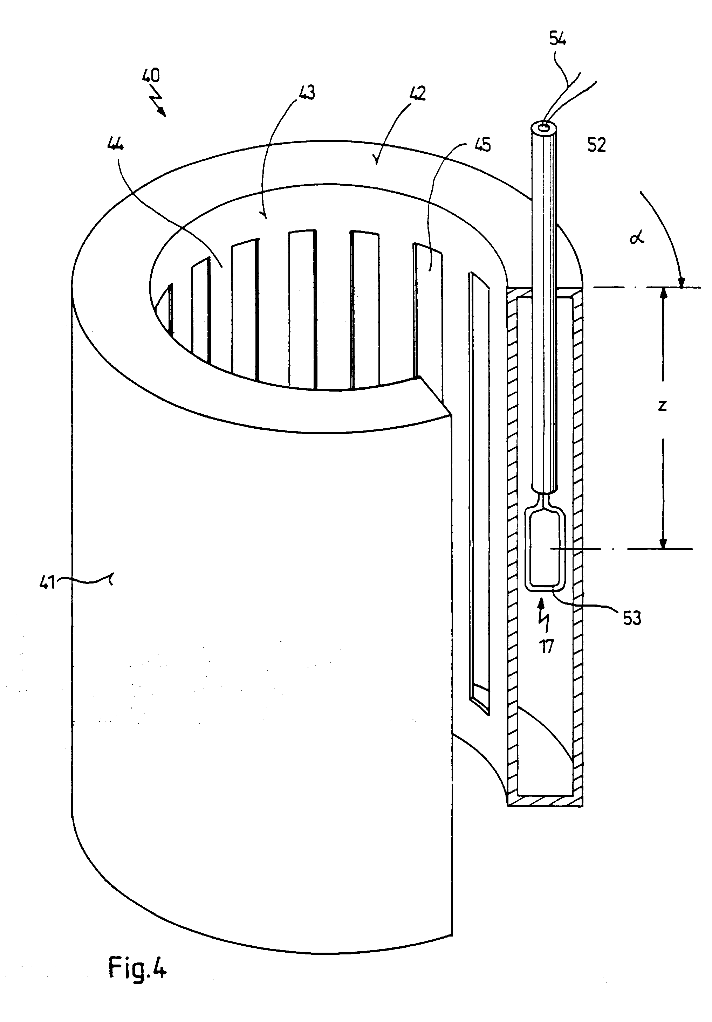

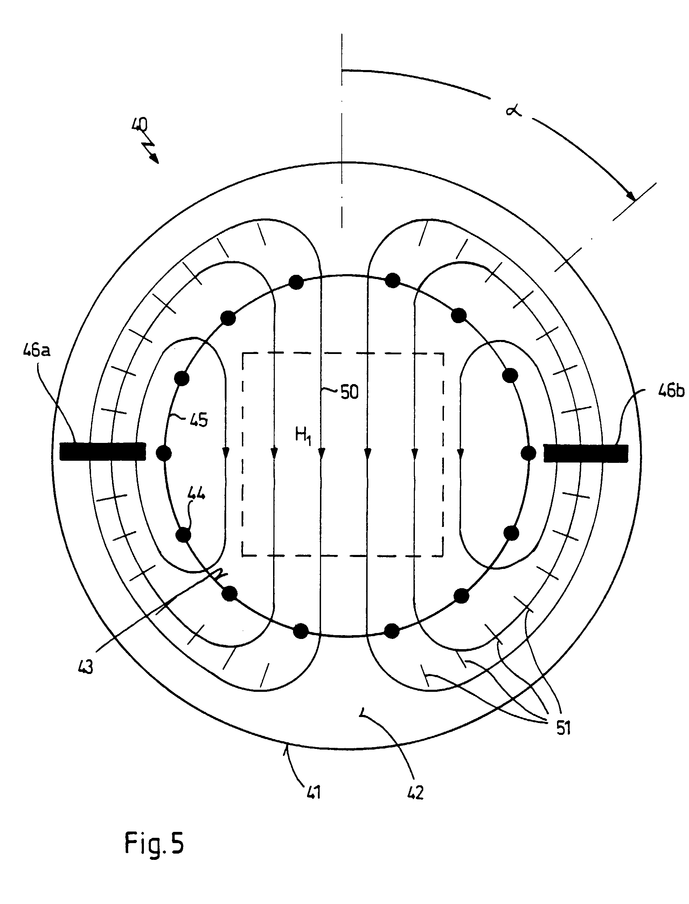

In den Fig. 4 und 5 ist nun als nicht-einschränkendes Beispiel eine Anbringungsart der Meßspule 17 erläutert.

Die Fig. 4 und 5 zeigen einen im wesentlichen hohlzylindrischen Resonator 40, dessen zylindrische Außenwand 41 und dessen Stirnwände 42 jeweils für Hochfrequenzströme geschlossen ausgebildet sind. Die zylindrische Innenwand 43 ist hingegen in axialer Richtung in leitende Stege 44 und nicht-leitende Schlitze 45 unterteilt. In Fig. 5 sind zusätzlich Ankoppelelemente 46a und 46b zu sehen, die im torusförmigen Zwischenraum zwischen den Wänden 41 und 43 in diametraler Position zueinander angeordnet sind.

Der Resonator 40 ist in den Fig. 4 und 5 nur äußerst schematisch dargestellt, weitere Einzelheiten hierzu finden sich in der DE-A-35 22 401, auf deren Offenbarung insoweit verwiesen werden soll.

In Fig. 5 sind mit 50 Feldlinien des Hochfrequenz-Magnetfeldes bezeichnet, die den Meßraum innerhalb der zylindrischen Innenwand 43 im wesentlichen homogen in radialer Richtung zur Längsachse des Resonators 40 durchsetzen.

Mit 51 sind mögliche Positionen für die Meßspule 17 bezeichnet. Die Meßspule 17 besteht vorzugsweise, wie Fig. 4 zeigt, aus einem in axialer Richtung verlaufenden Stab 52, der an seinem unteren Ende im Bereich des Zwischenraumes zwischen den Wänden 41 und 43 mit einer Drahtschleife 43 versehen ist. Die Drahtschleife 43 ist über Zuleitungen 54 mit dem Außenraum verbunden. Die Zuleitungen 54 münden dort in die Meßleitung 18.

In den Fig. 4 und 5 ist mit u ein Umfangswinkel bezeichnet, um den die Positionen 51 gegenüber einer Längsmittelebene versetzt sein können, die senkrecht zur Ebene der Ankoppelelemente 46 verläuft. Außerdem ist in Fig. 4 mit z die Eintauchtiefe der Drahtschleife 53 in den Zwischenraum zwischen den Wänden 41 und 43 bezeichnet.

Durch Variation von α und z kann nun eine optimale Position 51 nach Azimuth (α) und Tiefe (z) gefunden werden. Optimale Position bedeutet dabei die möglichst geringe Abhängigkeit der Proportionalität zwischen H₁ und Hₚ vom Füllfaktor η.

In praktischen Versuchen hat sich bei einem Resonator 40 der in Fig. 4 und 5 gezeigten Art gezeigt, daß eine optimale Position 51 bei einem Wert von α = 45° und einer Tiefe z erreicht werden kann, die etwa der halben axialen Länge des Resonators 40 entspricht.

Es hat sich ferner gezeigt, daß diese optimale Position für jeweils eine Art von Resonatoren 40 gilt, wie sie in der Praxis für bestimmte Typen von Untersuchungen verwendet werden. So wird in der Paxis z.B. ein großer Resonator 40 für Ganzkörpermessungen, ein zweiter, kleinerer Resonator, für Kopfmessungen und ein dritter, noch kleinerer Resonator, für Messungen an Gliedmaßen oder an kleinen Versuchstieren eingesetzt. Für jeden dieser Resonatortypen läßt sich die genannte optimale Position bestimmen und ist dann für jeden Füllfaktor, einschließlich variabler Position des Meßobjektes im Meßraum, mit hinreichender Genauigkeit brauchbar.

## Patentansprüche

1. Verfahren zum Kalibrieren einer ersten Hochfrequenz-Feldstärke (H₁) in einem von einer Hochfrequenzspule (13; 40) umgebenen und mit einem Meßobjekt (12) besetzten Meßraum eines Kernspintomographen (10), dadurch gekennzeichnet, daß zum Kalibrieren der ersten Hochfrequenzfeldstärke keine Kernspinresonanzmessung durchgeführt wird sondern vielmehr eine Hochfrequenzmessung an sich, indem die Hochfrequenzspule (13; 40) zunächst mit einem Hochfrequenzstrom vorgegebener Stromstärke (I_{c}) gespeist und eine sich infolgedessen einstellende zweite Hochfrequenzfeldstarke (Hₚ) an mindestens einer Position (17, 17') außerhalb des Meßraumes gemessen wird, wobei ferner aus der vorgegebenen Stromstärke (I_{c}), der gemessenen zweiten Feldstärke (Hₚ) und einer vorgegebenen ersten Proportionalität zwischen der ersten (H₁) und der zweiten (Hₚ) Feldstärke eine zweite Proportionalität zwischen dem die Hochfrequenzspule (13; 40) durchfließenden Strom (I) und der ersten Feldstärke (H₁) ermittelt und schließlich anhand der zweiten Proportionalität durch Einstellen eines Meßstromes (Iₘ) in der Hochfrequenzspule (13; 40) eine gewünschte, kalibrierte erste Feldstärke (Hₘ) in der Hochfrequenzspule (13; 40) erzeugt wird.

2. Verfahren nach Anspruch 1, dadurch gekennzeichnet, daß die zweite Feldstärke (Hₚ) in einem torusförmigen Zwischenraum zwischen einer zylindrischen Innenwand (43) und einer zylindrischen Außenwand (41) eines hohlzylindrischen Bandleitungsresonators (40) gemessen wird.

3. Vorrichtung für die Kernspintomographie mit einem von einer Hochfrequenzanordnung umgebenen und mit einem Meßobjekt (12) besetzbaren Meßraum, wobei die Hochfrequenzanordnung über einen Verstärker (15) mit einem Hochfrequenzstrom (I) beaufschlagbar ist und eine zum Senden und Empfangen von Kernspintomographie-Hochfrequenzsignalen vorgesehene Hochfrequenzspule (13; 40) umfaßt, dadurch gekennzeichnet, daß zum Kalibrieren einer ersten Hochfrequenzfeldstärke (H₁) in dem Meßraum ohne Durchführung einer Kernspinresonanzmessung eine zusätzlich zu der Hochfrequenzspule (13; 40) vorgesehene Meßspule (17) außerhalb des Meßraumes angeordnet ist, und daß der Hochfrequenzstrom (I) in Abhängigkeit von einem Ausgangssignal der Meßspule (17) einstellbar ist, zu welchem Zweck der Verstärker (15) in seinem Verstärkungsfaktor einstellbar ist und ein Verstärkungs-Steuereingang des Verstärkers (15) an einen Regler (19) angeschlossen ist, dessen Eingang (20) mit der Meßspule (17) verbunden ist.

4. Vorrichtung nach Anspruch 3, dadurch gekennzeichnet, daß der Verstärker (15) eingangsseitig wahlweise mit einem Kernresonanz-Impulsgenerator (16) oder mit einem kalibrierten Hochfrequenzgenerator (22) verbindbar ist.

5. Vorrichtung nach Anspruch 3 oder 4, dadurch gekennzeichnet, daß die Meßspule (17) an einen mit einem Alarmausgang (25) versehenen Regler (19) angeschlossen ist.

6. Vorrichtung nach einem oder mehreren der Ansprüche 3 bis 5, dadurch gekennzeichnet, daß die Meßspule (17) in einem torusförmigen Zwischenraum zwischen einer zylindrischen Innenwand (43) und einer zylindrischen Außenwand (41) eines hohlzylindrischen Bandleitungsresonators (40) angeordnet ist.

7. Vorrichtung nach Anspruch 6, dadurch gekennzeichnet, daß die Meßspule (17) gegenüber an diametralen Positionen des Zwischenraumes angeordneten Ankoppelelementen (46a, 46b) um 45° versetzt angeordnet ist.

8. Vorrichtung nach einem oder mehreren der Ansprüche 3 bis 7, dadurch gekennzeichnet, daß mehrere Meßspulen (17, 17') vorgesehen sind, und daß die Ausgangssignale der Meßspulen (17, 17') zum Zwecke der Mittelwertbildung miteinander verknüpft werden.

## Claims

1. A method for calibrating a first high frequency field strength (H₁) within a measuring volume of a nuclear spin tomograph (10), the measuring volume being occupied by a measuring object (12) and surrounded by a high frequency coil (13; 40), characterized in that for calibrating the first high frequency field strength no nuclear spin resonance measurement but instead a high frequency measurement as such is carried out, in that the high frequency coil (13; 40) is firstly supplied with a high frequency current of predetermined intensity (I_{c}) and a second high frequency field strength (Hₚ), occurring thereby, is measured at at least one location (17, 17') outside the measuring volume, wherein a second proportionality between the current (I) flowing through the high frequency coil (13; 40) and the first field strength (H₁) is determined from the predetermined current intensity (I_{c}) and the measured second field strength (Hₚ) and a predetermined first proportionality between the first (H₁) and the second (Hₚ) field strength, and wherein, finally, a desired calibrated first field strength (Hₘ) is generated within the high frequency coil (13; 40) by the help of the second proportionality through setting a measuring current (Iₘ) in the high frequency coil (13; 40).

2. The method of claim 1, characterized in that the second field strength (Hₚ) is measured in a toroidal space between a cylindrical inner wall (43) and a cylindrical outer wall (41) of a hollow-cylindrical strip line resonator (40).

3. An apparatus for nuclear spin tomography comprising a measuring volume adapted to be occupied by a measuring object (12) and being surrounded by a high frequency assembly, the high frequency assembly being adapted to be supplied with a high frequency current (I) via an amplifier (15) and including a high frequency coil (13; 40) for transmitting and receiving nuclear spin tomography high frequency signals, characterized in that for calibrating a first high frequency field strength (H₁) within the measuring volume a pickup coil (17) provided in addition to the high frequency coil (13; 40) is disposed outside the measuring volume without carrying out a nuclear spin resonance measurement, and that the high frequency current (I) may be set dependent on an output signal fom the pickup coil (17), the amplifier being adjustable in its amplification factor for that purpose and an amplification control input of the amplifier (15) being connected to a controller (19), an input (20) of which being connected to the pickup coil (17).

4. The apparatus of claim 3, characterized in that the amplifier (15) may be connected at its input either with a nuclear resonance pulse generator (16) or with a calibrated high frequency generator (22).

5. The apparatus of claim 3 or 4, characterized in that the pickup coil (17) is connected to a controller (19) having an alarm output (25).

6. The apparatus of one or more of claims 3 through 5, characterized in that the pickup coil (17) is disposed in a toroidal space between a cylindrical inner wall (43) and a cylindrical outer wall (41) of a hollow cylindrical strip line resonator (40).

7. The apparatus of claim 6, characterized in that the pickup coil (17) is disposed at a location offset by 45° with respect to coupling elements (46a, 46b) arranged in the space at diametrically opposite positions.

8. The apparatus of one or more of claims 3 through 7, characterized in that several pickup coils (17, 17') are provided, output signals from the pickup coils (17, 17') being coupled together for averaging purposes.

## Revendications

1. Procédé de calibration d'une première intensité de champ haute fréquence (H₁) dans le volume de mesure d'un tomographe à résonance magnétique de spins (10) entouré par une bobine haute fréquence (13 ; 40) et occupé par un objet de mesure (12), caractérisé en ce que, pour la calibration de la première intensité de champ haute fréquence, au lieu d'une mesure de résonance magnétique de spins, est effectuée, au contraire, une mesure haute fréquence, en alimentant tout d'abord la bobine haute fréquence (13 ; 40) avec un courant haute fréquence d'intensité (I_{c}) définie au préalable et en ce qu'une seconde intensité de champ haute fréquence (Hₚ) qui s'établit en conséquence est mesurée en une position au moins (17, 17') à l'extérieur du volume de mesure, une première proportionnalité prédéterminée étant alors établie, à partir des valeurs d'intensité prédéterminées (I_{c}) de la seconde intensité de champ mesurée (Hₚ), entre la première (H₁) et la seconde (Hₚ) intensités de champ, ainsi qu'une seconde proportionnalité entre le courant (I) circulant dans la bobine haute fréquence (13 ; 40) et la première intensité de champ (H₁), pour obtenir finalement, à partir de cette seconde proportionnalité, par réglage d'un courant de mesure (Iₘ) dans la bobine haute fréquence (13 ; 40), une première intensité de champ (Hₘ) dans la bobine haute fréquence (13 ; 40), calibrée tel que recherché.

2. Procédé selon la revendication 1, caractérisé en ce que la seconde intensité de champ haute fréquence (Hₚ) est mesurée dans l'espace torique formé entre la paroi cylindrique interne (43) et la paroi cylindrique externe (41) d'un résonateur à ruban (40) en forme de cylindre creux.

3. Appareil pour la tomographie à résonance magnétique de spins comportant un volume de mesure entouré par un dispositif haute fréquence et dans lequel peut prendre place un objet de mesure (12), un courant haute fréquence (I) pouvant être appliqué par l'intermédiaire d'un amplificateur (15) au dispositif haute fréquence qui comporte une bobine haute fréquence (13 ; 40) prévue pour envoyer et pour recevoir des signaux haute fréquence de tomographie à résonance magnétique de spins, caractérisé en ce que, pour la calibration d'une première intensité de champ haute fréquence (H₁) dans le volume de mesure sans effectuer de mesure de résonance magnétique de spins, il est prévu, en plus de la bobine haute fréquence (13 ; 40), une bobine de mesure (17) disposée en dehors du volume de mesure et en ce que le courant haute fréquence (I) est réglable en fonction d'un signal de sortie de la bobine de mesure (17), le facteur d'amplification de l'amplificateur (15) étant réglable à cet effet et une entrée de commande d'amplification de l'amplificateur (15) étant raccordée en sortie d'un régulateur (19) dont l'entrée (20) est reliée à la bobine de mesure (17).

4. Appareil selon la revendication 3, caractérisé en ce que l'amplificateur (15) est relié en entrée soit à un générateur d'impulsions de résonance magnétique (16) soit à un générateur haute fréquence (22) calibré.

5. Appareil selon l'une ou l'autre des revendications 3 et 4, caractérisé en ce que la bobine de mesure (17) est raccordée à un régulateur (19) comportant une sortie alarme (25).

6. Appareil selon une ou plusieurs des revendications 3 à 5, caractérisé en ce que la bobine de mesure (17) est disposée dans l'espace torique formé entre la paroi cylindrique interne (43) et la paroi cylindrique externe (41) d'un résonateur à ruban (40) en forme de cylindre creux.

7. Appareil selon la revendication 6, caractérisé en ce que la bobine de mesure (17) est placée avec un décalage angulaire de 45° par rapport à des éléments de couplage (46a, 46b) dont les positions sont diamétralement opposées dans le volume de mesure.

8. Appareil selon une ou plusieurs des revendications 3 à 7, caractérisé en ce que plusieurs bobines de mesure (17, 17') sont prévues et en ce que les signaux de sortie des bobines de mesure (17, 17') sont combinés pour obtenir la valeur moyenne de ceux-ci.
